# EUROPÄISCHE PATENTSCHRIFT

(11) **EP 2 860 459 B1**
(45) Veröffentlichungstag und Bekanntmachung des Hinweises auf die Patenterteilung: **17.03.2021**
(21) Anmeldenummer: 14180746.1
(22) Anmeldetag: 13.08.2014
(51) Int. Cl.: F24C 7/08, H03K 17/965, H03K 17/968

(54) **HAUSHALTSGERÄT**
HOUSEHOLD APPLIANCE
APPAREIL MÉNAGER

(30) Priorität: 03.09.2013 ES 201331297
(43) Veröffentlichungstag der Anmeldung: 15.04.2015
(73) Patentinhaber: BSH Hausgeräte GmbH, 81739 München (DE)
(72) Erfinder: Andrade Soares, Paulo Marcos, 39012 Santander (ES); Cabarga Herrera, Alejandro, 39011 Santander (ES); Peña Martín, Oscar, 39478 Boo de Pielagos (ES); Placer Maruri, Emilio, 39120 Liencres (ES)

(56) Entgegenhaltungen:
- EP-A1- 1 526 644
- EP-A1- 1 947 550
- EP-A1- 2 821 709
- EP-A2- 0 797 227
- DE-A1- 2 649 647
- DE-A1- 10 314 315
- DE-A1-102005 049 995
- DE-A1-102006 047 471

## Beschreibung

Die vorliegende Erfindung betrifft ein Haushaltsgerät, wie beispielsweise ein Kochfeld oder Gasherd.

Bedienanordnungen umfassen häufig bewegliche Teile, wie beispielsweise Bedienknebel, Schieber oder Taster, damit der Benutzer Betriebszustände des Haushaltsgeräts einstellen kann. Bei einer Bedienanordnung muss dann die von einem Nutzer gewählte Einstellung in mechanische oder elektrische Signale umgewandelt werden, um einen Betriebszustand des Haushaltsgeräts entsprechend anzupassen. In der Vergangenheit sind beispielsweise drehbare Bedienknöpfe an Potentiometer gekoppelt worden, die in Abhängigkeit von dem eingestellten Widerstand ein elektrisches Signal an weitere Steuereinrichtungen lieferte. Darüber hinaus sind auch Schalter als Teile von Bedienanordnungen verwendet worden.

Es ist dabei wünschenswert, den häufig knappen Bauraum in Haushaltsgeräten günstig zu nutzen. Es wurde daher vorgeschlagen, optische Kopplungen zu verwenden. Dabei sind beispielsweise zwischen einer LED als Emitter und einem Photorezeptor als Empfänger Codierscheiben vorgesehen worden. In Abhängigkeit von einer Stellung der Codierscheibe, die zwischen dem Photorezeptor und dem LED-Emitter liegt, können weitere Steuersignale erzeugt werden. In Zusammenhang mit einem Herd ist beispielsweise in der WO 2013/041518 A1 ein drehbarer Bedienknebel mit einer Codierscheibe ausgestattet worden, die zwischen einer Sende-/Empfängeranordnung für Licht drehbar ist.

Die EP 0 797 227 A2 zeigt ein drehbares Bedienelement mit einer Lichtquelle und mehreren Lichtsensoren zur Detektion einer Lage oder einer Änderung der Lage des Bedienelements. Die DE 103 14 315 A1 zeigt ein Bedienelement, bei dem das Licht eine Lichtquelle mithilfe eines Lichtverteilers an mehrere Empfänger geleitet wird. Auf diese Weise werden Bewegungs- und Richtungsinformationen des Bedienelements ermittelt. Die DE 10 2005 049995 A1 beschreibt eine Bedienvorrichtung mit einem magnetischen Metallstern und mehreren Hall-Sensoren zur Bestimmung einer Drehbewegung der Bedienvorrichtung. Die EP 1 947 550 A1 zeigt eine berührungssensitive, opto-elektrische Eingabevorrichtung für Haushaltsgeräte, bei der mithilfe von evaneszenten Feldern eine Berührungsstelle an Grenzflächen eines Lichtleiters ermittelt werden kann. Die DE 10 2006 047 471 A1 offenbart einen Impulsgeber für ein Bedienelement in einem Kraftfahrzeug, in dem Licht aus einer Lichtquelle mittels einer Lichtverteilung weiterleitbar ist, und die Lichtquelle und der Lichtempfänger ein auswertbares Signal generieren. Die EP 1 526 644 A1 offenbart ein Bedienfeld eines Kraftfahrzeugs mit mindestens einem Drehknopf, der ein vorstehendes drehbewegliches Teil hat, das durch eine optische Erfassungseinrichtung detektiert werden kann.

Die EP 2 821 709 A1 offenbart eine Bedienvorrichtung für ein Haushaltsgerät, mit einem Bedienelement, welches auf einer Bedienelementaufnahme des mit der Bedienvorrichtung steuerbaren Haushaltsgeräts mittels Magnetkraft haltbar und relativ zur Bedienelementaufnahme bewegbar und von dort abnehmbar positionierbar ist.

Nachteilig hat sich die erforderliche Bauhöhe, welches sich aus den Dimensionen von Codierscheibe, Lichterzeuger oder Lichtquelle und Photorezeptor ergibt. Ferner erfordert eine auf einer Achse des Drehknebels aufgesetzte Codierscheibe meist eine Öffnung in einer Kochfeldplatte oder einem Verblendelement.

Vor diesem Hintergrund ist es eine Aufgabe der vorliegenden Erfindung, eine verbesserte Bedienanordnung eines erfindungsgemäßen Haushaltgerätes bereitzustellen.

Demgemäß wird ein Haushaltsgerät vorgeschlagen. Die Bedienanordnung des erfindungsgemäßen Haushaltgerätes umfasst ein Sendeelement zum Erzeugen einer Sendestrahlung, ein Empfangselement zum Erfassen einer Empfangsstrahlung und ein Strahlungsleitelement, welches derart beweglich angeordnet ist, dass in Abhängigkeit von einer Stellung eines Bedienelements des Haushaltsgeräts eine Übertragung der Sendestrahlung von dem Sendeelement in Richtung zu dem Empfangselement verändert wird. Das Sendeelement und das Empfangselement sind dabei insbesondere auf derselben Seite bezüglich des Strahlungsleitelements angeordnet.

Bei der Bedienanordnung ergibt sich eine besonders niedrige Bauhöhe dadurch, dass das Sende- und das Empfangselement beispielsweise nebeneinander angeordnet sind und sich eine Bauhöhe lediglich aus der Höhe der einzelnen Sende- und Empfangselemente ergibt. Im Vergleich zu den bekannten optischen Codierern als Bedienanordnungen wird ein geringerer Bauraum benötigt, denn die Bauhöhen der Sende- und Empfangselemente addieren sich nicht mit dem dazwischen liegenden Strahlungsleitelement, das beispielsweise eine Codierscheibe ist.

Durch die Verwendung von Sende- und/oder Empfangsstrahlung, die beispielsweise ein entsprechend transparentes Verblendelement oder eine Kochfeldplatte durchdringen kann, ist eine Kopplung des Strahlungsleitelementes mit dem Sende- und Empfangselement ohne Durchbrechen des Verblendelements oder der Kochfeldplatte möglich.

In Ausführungsformen sind das Sendeelement und das Empfangselement nebeneinander angeordnet und weisen beispielsweise in dieselbe Richtung. Das Strahlungsleitelement liegt dem Sende- und Empfangselement gegenüber.

In Ausführungsformen sind das Sendeelement und das Empfangselement derart zueinander angeordnet, dass in keiner Betriebssituation des Haushaltsgerätes eine direkte Strahlung von dem Sendeelement zu dem Empfangselement gelangt. Eine Übertragung von der Strahlung des Sendeelements zum Empfangselement erfolgt insofern ausschließlich mit Hilfe des Strahlungsleitelements. Das Sendeelement hat z.B. eine Vorzugsrichtung für eine Abstrahlung der Sendestrahlung, und das Empfangselement hat eine Vorzugsrichtung für ein Erfassen der Empfangsstrahlung. Bei einer Implementierung als Lichtsender und Lichtsensor weisen die beiden Vorzugsrichtungen beispielsweise zu dem Strahlungsleitelement.

In Ausführungsformen ist das Strahlungsleitelement beispielsweise in der Art eines Abdeckelements derart eingerichtet, dass in Abhängigkeit von der Stellung des Bedienelements ein Strahlungstransport von dem Sendeelement zu dem Empfangselement unterbunden oder freigegeben wird. Deckt beispielsweise das Strahlungsleitelement das Sende- oder Empfangselement ab, kann keine Strahlung zwischen Sende- und Empfangselement übertragen werden. Beispielsweise ist das Strahlungsleitelement für die Sende- und/oder Empfangsstrahlung zumindest teilweise undurchlässig. Ist insbesondere das Strahlungsleitelement an ein Bedienelement gekoppelt, welches beweglich ist, kann in Abhängigkeit von der Stellung des Bedienelementes und damit des Strahlungsleitelementes die Position erkannt werden und in ein entsprechendes Signal für einen Betriebszustand umgewandelt werden.

Insofern ergibt sich die Möglichkeit einer Codierung aus der relativen Position von Sendeelement, Empfangselement und Strahlungsleitelement.

In Ausführungsformen der Bedienanordnung ist das Strahlungsleitelement derart eingerichtet, dass in Abhängigkeit von der Stellung des Bedienelementes die Sendestrahlung von dem Sendeelement in Richtung zu dem Empfangselement gelenkt wird.

Eine Umlenkung kann beispielsweise durch eine Strahlungsleitung, wie beispielsweise einen optischen Leiter, oder eine Reflexion der Sendestrahlung zum Empfangselement hin erfolgen. Insofern kann man von einem Umlenkelement sprechen, welches entweder für die Sende- und/oder Empfangsstrahlung teilweise transparent ist oder in Abhängigkeit von der Stellung des Bedienelements die Sendestrahlung und zu dem Empfangselement reflektiert.

Darüber hinaus ist es auch möglich, das Strahlungsleitelement als einen Wellenlängenverschieber einzusetzen, d.h. das Empfangselement empfängt in Abhängigkeit von einer Stellung des Bedienelementes, an dem beispielsweise das Strahlungsleitelement als Wellenlängenverschieber angeordnet ist, in Abhängigkeit von der Stellung unterschiedliche Wellenlängen. Insofern kann in Abhängigkeit von dem empfangenen Licht bzw. der Lichtfrequenz oder der Wellenlänge auf eine Position, Stellung oder einen Drehwinkel des Bedienelements geschlossen werden.

In Ausführungsformen der Bedienanordnung des erfindungsgemäßen Haushaltgerätes sind das Sendeelement und das Empfangselement nebeneinander auf einer gemeinsamen Trägerplatte angeordnet. Die Trägerplatte kann beispielsweise eine Platine oder Leiterplatte sein.

Vorzugsweise ist das Strahlungsleitelement gegenüber von der Trägerplatte, dem Sendeelement und dem Empfangselement beweglich angeordnet. Das Strahlungsleitelement ist insbesondere an ein Bedienelement gekoppelt oder ist Teil desselben.

In Ausführungsformen ist das Sendeelement eingerichtet, im Wesentlichen senkrecht die Sendestrahlung von der Trägerplatte weg abzustrahlen. Das Empfangselement kann insbesondere eingerichtet sein, die Empfangsstrahlung im Wesentlichen senkrecht zu der Trägerplatte zu erfassen. In Ausführungsformen kann das Sendeelement die Strahlung von der Trägerplatte weg emittieren, und das Empfangselement erfasst oder detektiert im Wesentlichen Strahlung, die senkrecht auf die Trägerplatte einstrahlt.

Die Bedienanordnung kann darüber hinaus eine Auswerteeinrichtung umfassen, welche an das Empfangselement gekoppelt ist und eingerichtet ist, in Abhängigkeit von der erfassten Empfangsstrahlung ein Steuersignal für das Haushaltsgerät zu erzeugen. Das Steuersignal kann beispielsweise zur Einstellung eines Betriebsmodus des Haushaltsgerätes weiter verarbeitet werden. Unter einem Steuersignal wird auch ein Signal verstanden, das lediglich die Position oder Stellung des jeweiligen Bedienelementes anzeigt.

In Ausführungsformen der Bedienanordnung sind dem Bedienelement mehrere Paare von Sende- und Empfangselementen zugeordnet. Erfindungsgemäß ist ein einziges Strahlungsleitelement an einem Bedienelement angeordnet, welches bei der Betätigun des Bedienelementes über Paare von Sende- und Empfangselementen verfährt. Insofern können einzelne Empfangssignale von den Empfangselementen zu einer Steuereinrichtung geführt werden, so dass erkannt werden kann, über welchem der mehreren Paare von Sende- und Empfangselementen das Strahlungsleitelement vorliegt. Vorzugsweise ist die Sende- und/oder Empfangsstrahlung optische Strahlung, und insbesondere Infrarotstrahlung. Dann lassen sich leicht ein Infrarotsender und ein Infrarotsensor, die kompakt herstellbar sind, nebeneinander anordnen.

Darüber hinaus wird ein Haushaltsgerät vorgeschlagen, beispielsweise ein Gaskochfeld oder ein Gasherd, welches eine Bedienanordnung wie vorbeschrieben aufweist. Vorzugsweise wird in Abhängigkeit von dem Steuersignal ein Betriebsmodus des Haushaltsgerätes eingestellt.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.
Fig. 1 zeigt eine schematische Darstellung einer Ausführungsform einer Bedienanordnung für ein Haushaltsgerät;
Fig. 2 zeigt eine perspektivische Darstellung einer weiteren Ausführungsform einer Bedienanordnung für ein Haushaltsgerät; und
Fig. 3 zeigt eine Draufsicht der Ausführungsform einer Bedienanordnung gemäß Fig. 2.

In den Figuren sind gleiche oder funktionsgleiche Elemente mit denselben Bezugszeichen versehen, sofern nichts anderes angegeben ist.

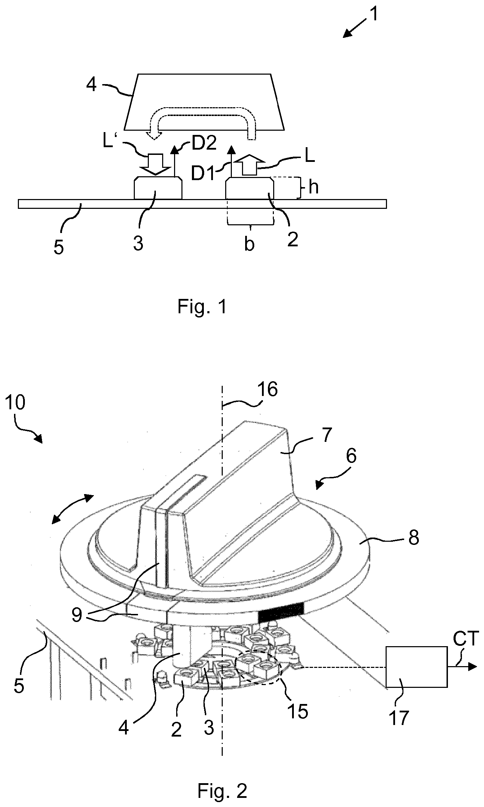

Die Fig. 1 zeigt eine schematische Darstellung einer Ausführungsform für eine Bedienanordnung für ein Haushaltsgerät. Die Bedienanordnung 1 umfasst dabei ein Sendeelement 2 für Sendestrahlung L und ein Empfangselement 3 für Empfangsstrahlung L'. Das Sendeelement 2 ist beispielsweise eine LED oder eine Lichtquelle, die im Wesentlichen gerichtet Strahlung abstrahlt. Es kann sich beispielsweise um eine Infrarot-LED handeln. Das Empfangselement 3 ist beispielsweise ein Infrarotsensor, der Infrarotstrahlung erkennen kann. Man kann auch von einer Sender-/Empfängeranordnung oder Emitter-Sensoranordnung sprechen. Das Sendeelement 2 und das Empfangselement 3 sind benachbart zueinander auf einer Trägerplatte 5 angeordnet.

In der Fig. 1 ist eine Vorzugsrichtung D1 für das Aussenden von Sendestrahlung L ausgehend vom Sendeelement 2 und eine Vorzugsrichtung D2 für zu detektierendes oder erfassendes Empfangslicht L' für das Empfangselement 3 angedeutet. Bei der Trägerplatte 5 handelt es sich beispielsweise um eine Platine, die eine weitere Verdrahtung oder zusätzliche Elemente umfassen kann. Die Bedienanordnung 1 umfasst darüber hinaus ein Strahlungsleitelement 4.

Das Strahlungsleitelement 4 ermöglicht eine Umlenkung des in der Orientierung der Fig. 1 nach oben ausgesendeten Lichts L in praktisch entgegengesetzter Richtung als Empfangslicht L'. Die Umlenkung ist in der Fig. 1 über den gestrichelten Pfeil angedeutet. Insofern kann das Sendelicht L oder die Sendestrahlung nur zu dem Empfangselement 3 gelangen, wenn das Strahlungsleitelement 4 entsprechend positioniert ist. Die Umlenkung kann dabei beispielsweise durch eine materialmäßige Ausgestaltung des Umlenk- oder Strahlungsleitelementes 4 erfolgen. Die Umlenkung kann durch Reflektion oder Lichtleitung innerhalb des Umlenkelementes 4 vollzogen werden. Denkbar ist auch eine Reflektion an der Unterseite des Umlenkelementes 4 von dem Sendeelement 2 zum Empfangselement 3.

In einer alternativen Ausgestaltung ist es auch möglich, das Strahlungsleitelement 4 beispielsweise kammartig derart auszuführen, dass beim Verfahren über das Sende- oder Empfangselement 2, 3 die jeweilige Fläche, die zum Lichtaussenden oder -empfangen eingerichtet ist, abgedeckt wird. Insofern ist in Abhängigkeit von einer Position des Strahlungsleitelements 4 relativ zu den Sende- und Empfangselementen 2, 3 erkennbar, wo sich das Umlenkelement 4 befindet. Man erkennt anhand der Fig. 1, dass beispielsweise übliche Infrarot- oder lichtemittierende Dioden als Sendeelemente 2 eine relativ niedrige Bauhöhe h im Vergleich zu ihrer lateralen Ausdehnung b haben. Insofern sind Sendeelemente in der Regel flacher als breit. Ähnlich sind Infrarotsensoren oder licht-/
photosensitive Sensoren als Empfangselemente 3 flacher als ihre Bauhöhe h. Da die beiden Elemente 2, 3 nebeneinander angeordnet sind, ergibt sich so insgesamt eine besonders niedrige Bauhöhe für die Bedienanordnung 1. Das Strahlungsleitelement, welches als Abdeck- oder Umlenkelement 4 ausgestaltet sein kann, ist dabei beispielsweise an einem Bedienknebel befestigt, der drehbar oder anders beweglich ist.

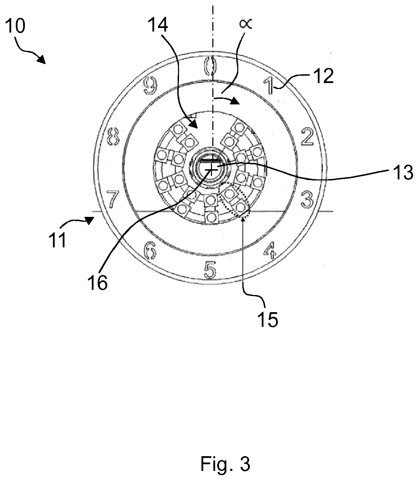

In den Fig. 2 und 3 sind Darstellungen einer weiteren Ausführungsform einer Bedienanordnung für ein Haushaltsgerät dargestellt.

Die Fig. 2 zeigt eine perspektivische Darstellung und die Fig. 3 eine Draufsicht der weiteren Ausführungsform. Dabei umfasst die weitere Ausführungsform für eine Bedienanordnung 10 ein Bedienelement 6, beispielsweise einen Bedienknebel, der ein Handhabungselement 7 als Griff und eine scheibenförmige Grundplatte 8 umfasst. Es sind Positionsmarkierungen 9 an einer Seite des Handhabungselements 7 vorgesehen, so dass ein Bediener den Bedienknebel in der Art eines Zeigers entlang einer Skala 12, die in der Fig. 3 angedeutet ist, einstellen kann. Um die Bedienung des jeweiligen Haushaltsgerätes, beispielsweise eines Gasherdes oder eines Gaskochfeldes, zu ermöglichen, ist es notwendig, die Stellung und insbesondere die Winkelposition des Bedienknebels 7 bezüglich seiner Drehachse 16 zur Skala 12 zu erkennen.

In der Fig. 3 erkennt man in der Darstellung der Bedienanordnung mit abgenommenem Bedienknebel die Welle oder Achse 13, welche die Rotationsachse 16 definiert. Der Winkel α zeigt die Winkelstellung des Drehknebels 6 an. An der Unterseite der Scheibe 8 ist ein Strahlungsleitelement 4, wie es beispielsweise bezüglich der Fig. 1 erläutert wurde, vorgesehen. Unterhalb des beweglichen Drehknebels 6 und damit des beweglichen Strahlungsleitelementes 4 sind mehrere Paare 15 von Sende- und Empfangselementen 2, 3 vorgesehen. Die Paare 15 sind um den Umfang herum unterhalb der Scheibe 8 an verschiedenen Winkelpositionen beispielsweise gemäß der Skala 12 kreisförmig angeordnet. Die jeweiligen Paare 15 von Sende-/Empfangs- und Empfangselementen 2, 3 sind dabei auf einer Leiterplatte 5 vorgesehen.

Die jeweiligen Sende-/Empfangselemente 2, 3 liefern Empfangssignale an eine Auswerteeinrichtung 17, die eines oder mehrere Steuersignale CT für das Haushaltsgerät liefert. Je nachdem, oberhalb welchem Sende-/Empfangspaar 15 das Strahlungsleitelement 4 vorliegt, wird ein entsprechendes Empfangssignal an die Auswerteeinrichtung 17 geliefert. Beispielsweise kann das Strahlungsleitelement 4, wie es in der Fig. 2 dargestellt ist, die beiden mit 2, 3 bezeichneten Sende- und Empfangselemente überdecken. Je nach Ausgestaltung des Strahlungsleitelements 4 liefert das jeweilige Empfangselement 3 ein Signal in Abhängigkeit von der erfassten Strahlung, die von dem Sendeelement 2 herrührt, an die Auswerteeinrichtung 17.

Die vorgeschlagene Bedienanordnung 1, 10 hat eine besonders niedrige Bauhöhe, so dass die Trägerplatte als Platine 5 mit den darauf angeordneten Sende- und Empfangselementen 2, 3 sehr nahe beispielsweise unterhalb einer Kochfeldplatte angeordnet werden kann. Dadurch ergeben sich insgesamt besonders flache Kochfelder oder insbesondere flache Einbaukochmulden. In Ausführungsformen haben die Infrarotsensoren Bauhöhen h von kleiner als 5 mm. Vorzugsweise sind die Sende- und/oder Empfangseinrichtungen bzw. -elemente niedriger als 2 mm. Insofern ergibt sich eine besonders flache Ausgestaltung mit niedriger Bauhöhe für die Bedienanordnung 1, 10.

Man erkennt in der Fig. 3, dass der an der Unterseite des Bedienknebels 6 angeordnete Umlenk-, Abdeck- oder Strahlungsleitabschnitt 4 durch eine Öffnung 14 in der beispielsweise als Skalenplatte ausgestalteten Ebene verläuft. Es ist mit Hilfe von mehreren Paaren 15 von Sende- und Empfangselementen 2, 3 besonders einfach, viele Positionen von Bedienknebeln 6 oder auch anderen Bedienelementen, die beweglich sind, zu erfassen.

Eine Codierung, wie sie Codierscheiben vollziehen, lässt sich auch mit Hilfe einer oder mehrerer Strahlungsleitelemente 4, die an dem Bedienelement 6 angeordnet sind, erzielen. Beispielsweise können insbesondere die Empfangselemente 3 Signale in Abhängigkeit von einer Empfangsstrahlungs- oder Empfangslichtstärke oder Wellenlänge liefern. Die Strahlungsleitelemente 4 können als Filter ausgestaltet werden, so dass eine veränderte Position des Strahlungsleitelementes 4 oberhalb des Paares 15 von Sende- und Empfangselement 2, 3 zu einer veränderten Übertragung des Sendelichts zum Empfänger führt. Diese Veränderung ist dann ein Indikator für die Stellung des Bedienelementes 6.

Schließlich werden die Steuersignale CT von der Auswerteeinrichtung 17 an weitere, beispielsweise elektronische Steuerungen des Haushaltsgerätes geliefert. In der Folge wird der vom Bediener eingestellte Betriebsmodus beispielsweise eine Heizleistung eines Gasbrenners, die durch die Skala 12 angegeben sein kann, eingestellt.

Obwohl die Erfindung vorliegend anhand bevorzugter Ausführungsbeispiele beschrieben wurde, ist sie darauf nicht beschränkt, sondern vielfältig modifizierbar. Beispielsweise kann das Strahlungsleitelement Teil des Bedienelements sein. Denkbar ist, dass das Strahlungsleitelement in das Bedienelement integriert ist.

### Verwendete Bezugszeichen:

- 1: Bedienanordnung
- 2: Sendeelement
- 3: Empfangselement
- 4: Strahlungsleitelement
- 5: Trägerplatte
- 6: Bedienelement
- 7: Handhabungsabschnitt
- 8: Scheibe
- 9: Markierung
- 10: Bedienanordnung
- 11: Skalenkranz
- 12: Skala
- 13: Welle/Achse
- 14: Öffnung
- 15: Sende- Empfangspaar
- 16: Drehachse
- 17: Auswerteeinrichtung

- b: Breite
- CT: Steuersignale
- D1, D2: Vorzugsrichtung
- h: Bauhöhe
- L: Sendestrahlung
- L': Empfangsstrahlung
- α: Drehwinkel

## Patentansprüche

1. Haushaltsgerät mit einer Bedienanordnung (1) mit einem Sendeelement (2) zum Erzeugen einer Sendestrahlung (L), einem Empfangselement (3) zum Erfassen einer Empfangsstrahlung (L') und mit einem einzigen Strahlungsleitelement (4), welches derart beweglich angeordnet ist, dass in Abhängigkeit von einer Stellung eines Bedienelements (6) des Haushaltsgeräts eine Übertragung der Sendestrahlung (L) von dem Sendelement (2) in Richtung zu dem Empfangselements (3) als Empfangsstrahlung (L') verändert wird, wobei
das Sendelement (2) und das Empfangselement (3) auf derselben Seite des Strahlungsleitelements (4) angeordnet sind,
die Bedienanordnung (1) ferner eine Auswerteeinrichtung (17) aufweist, welche an das Empfangselement (3) gekoppelt ist und eingerichtet ist, in Abhängigkeit von der erfassten Empfangsstrahlung (L') ein Steuersignal für das Haushaltsgerät zu erzeugen, und
wobei das Haushaltsgerät eingerichtet ist, dass in Abhängigkeit von dem Steuersignal (CT) ein Betriebsmodus des Haushaltsgerätes eingestellt wird, **dadurch gekennzeichnet, dass** dem Bedienelement (6) mehrere Paare (15) von Sende- und Empfangselementen (2, 3) zugeordnet sind, das Strahlungsleitelement (4) bei einer Betätigung des Bedienelements (6) über die Paare (15) von Sende- und Empfangselementen (2, 3) verfährt, so dass erkannt wird, über welchem der mehreren Paare (15) von Sende- und Empfangselementen (2, 3) das Strahlungsleitelement (4) vorliegt.

2. Haushaltsgerät nach Anspruch 1, **dadurch gekennzeichnet, dass** das Strahlungsleitelement (4) derart eingerichtet ist, dass in Abhängigkeit von der Stellung des Bedienelements (6) ein Strahlungstransport von dem Sendelement (2) zu dem Empfangselements (3) unterbunden oder freigegeben wird.

3. Haushaltsgerät nach Anspruch 2, **dadurch gekennzeichnet, dass** das Strahlungsleitelement (4) für die Sende- und/oder Empfangsstrahlung (L, L') teilweise undurchlässig ist.

4. Haushaltsgerät nach einem der Ansprüche 1 - 3, **dadurch gekennzeichnet, dass** das Strahlungsleitelement (4) derart eingerichtet ist, dass in Abhängigkeit von der Stellung des Bedienelements (6) die Sendestrahlung (L) von dem Sendelement (2) in Richtung zu dem Empfangselements (3) gelenkt wird.

5. Haushaltsgerät nach einem der Ansprüche 1 - 4, **dadurch gekennzeichnet, dass** das Strahlungsleitelement (4) für die Sende- und/oder Empfangsstrahlung (L, L') zumindest teilweise transparent ist.

6. Haushaltsgerät nach einem der Ansprüche 1 - 5, **dadurch gekennzeichnet, dass** das Strahlungsleitelement (4) eingerichtet ist, in Abhängigkeit von der Stellung des Bedienelements (6) die Sendestrahlung (L) in Richtung zu dem Empfangselements (3) zu reflektieren.

7. Haushaltsgerät nach einem der Ansprüche 1 - 6, **dadurch gekennzeichnet, dass** das Sendeelement (2) und das Empfangselement (3) nebeneinander auf einer gemeinsamen Trägerplatte (5) angeordnet sind.

8. Haushaltsgerät nach Anspruch 7, **dadurch gekennzeichnet, dass** das Strahlungsleitelement (4) gegenüber von der Trägerplatte (5), dem Sendeelement (2) und dem Empfangselement (3) beweglich angeordnet ist.

9. Haushaltsgerät (1) nach Anspruch 7 oder 8, **dadurch gekennzeichnet, dass** das Sendeelement (2) eingerichtet ist, im Wesentlichen senkrecht die Sendestrahlung (L) von der Trägerplatte (5) weg abzustrahlen.

10. Haushaltsgerät nach einem der Ansprüche 7 - 9, **dadurch gekennzeichnet, dass** das Empfangselement (3) eingerichtet ist, die Empfangsstrahlung (L') im Wesentlichen senkrecht zu der Trägerplatte (5) zu erfassen.

11. Haushaltsgerät nach einem der Ansprüche 1 - 10, ferner mit einem Bedienelement (6), an welches das Strahlungsleitelement (4) gekoppelt ist.

12. Haushaltsgerät nach einem der Ansprüche 1 - 11, **dadurch gekennzeichnet, dass** die Sende- und/oder Empfangsstrahlung (L, L') optische Strahlung, insbesondere Infrarotstrahlung ist.

13. Haushaltsgerät nach einem der Ansprüche 1 bis 12, welches ein Gaskochfeld ist.

## Claims

1. Household appliance with a control arrangement (1) with a transmit element (2) for generating transmit radiation (L), a receive element (3) for detecting receive radiation (L') and with a single radiation conduction element (4), which is arranged movably so that as a function of a position of a control element (6) of the household appliance, a transmission of the transmit radiation (L) from the transmit element (2) in the direction of the receive element (3) as receive radiation (L') is changed, wherein
the transmit element (2) and the receive element (3) are arranged on the same side of the radiation conduction element (4),
the control arrangement (1) also has an evaluation facility (17), which is coupled to the receive element (3) and is designed to generate a control signal for the household appliance as a function of the detected receive radiation (L'), and
wherein the household appliance is designed so that as a function of the control signal (CT) an operating mode of the household appliance is set, **characterised in that** a number of pairs (15) of transmit and receive elements (2, 3) are assigned to the control element (6), the radiation conduction element (4) travels across the pairs (15) of transmit and receive elements (2, 3) upon actuation of the control element (6), so that it is identified across which of the number of pairs (15) of transmit and receive elements (2, 3) the radiation conduction element (4) is present.

2. Household appliance according to claim 1, **characterised in that** the radiation conduction element (4) is designed so that as a function of the position of the control element (6), transportation of radiation from the transmit element (2) to the receive element (3) is prevented or released.

3. Household appliance according to claim 2, **characterised in that** the radiation conduction element (4) is partially impermeable for the transmit and/or receive radiation (L, L').

4. Household appliance according to one of claims 1 - 3, **characterised in that** the radiation conduction element (4) is designed so that as a function of the position of the control element (6), the transmit radiation (L) is directed from the transmit element (2) in the direction of the receive element (3).

5. Household appliance according to one of claims 1 - 4, **characterised in that** the radiation conduction element (4) is at least partially transparent for the transmit and/or receive radiation (L, L').

6. Household appliance according to one of claims 1 - 5, **characterised in that** the radiation conduction element (4) is designed to reflect the transmit radiation (L) in the direction of the receive element (3) as a function of the position of the control element (6).

7. Household appliance according to one of claims 1 - 6, **characterised in that** the transmit element (2) and the receive element (3) are arranged adjacent to one another on a shared carrier plate (5).

8. Household appliance according to claim 7, **characterised in that** the radiation conduction element (4) is arranged moveably opposite from the carrier plate (5), the transmit element (2) and the receive element (3).

9. Household appliance (1) according to claim 7 or 8, **characterised in that** the transmit element (2) is designed to emit the transmit radiation (L) away from the carrier plate (5) essentially at right angles.

10. Household appliance according to one of claims 7 - 9, **characterised in that** the receive element (3) is designed to detect the receive radiation (L') essentially at right angles to the carrier plate (5).

11. Household appliance according to one of claims 1 - 10, further with a control element (6), to which the radiation conduction element (4) is coupled.

12. Household appliance according to one of claims 1 - 11, **characterised in that** the transmit and/or receive radiation (L, L') is optical radiation, in particular infrared radiation.

13. Household appliance according to one of claims 1 to 12, which is a gas hob.

## Revendications

1. Appareil ménager avec un agencement de commande (1) avec un élément d'émission (2) pour la génération d'un rayonnement d'émission (L), un élément de réception (3) pour la perception d'un rayonnement de réception (L') et avec un seul élément conducteur de rayonnement (4), disposé de telle façon de manière mobile qu'une transmission du rayonnement d'émission (L) de l'élément d'émission (2) en direction de l'élément de réception (3) sous forme de rayonnement de réception (L') se trouve modifiée en fonction d'une position d'un élément de commande (6) de l'appareil ménager,
dans lequel l'élément d'émission (2) et l'élément de réception (3) sont disposés sur le même côté de l'élément conducteur de rayonnement (4),
dans lequel l'agencement de commande (1) présente en outre un dispositif d'évaluation (17), couplé à l'élément de réception (3) et aménagé afin de générer un signal de commande pour l'appareil ménager en fonction du rayonnement de réception (L') perçu, et
dans lequel l'appareil ménager est aménagé afin de cesser en fonction du signal de commande (CT) un mode de fonctionnement de l'appareil ménager, **caractérisé en ce que** plusieurs paires (15) d'éléments d'émission et de réception (2, 3) sont affectées à l'élément de commande (6), l'élément conducteur de rayonnement (4) se déplace lors d'un actionnement de l'élément de commande (6) sur les paires (15) d'éléments d'émission et de réception (2, 3), de sorte à distinguer sur laquelle des plusieurs paires (15) d'éléments d'émission et de réception (2, 3) l'élément conducteur de rayonnement (4) se trouve.

2. Appareil ménager selon la revendication 1, **caractérisé en ce que** l'élément conducteur de rayonnement (4) est aménagé de telle sorte qu'un transport du rayonnement de l'élément d'émission (2) vers l'élément de réception (3) est empêché ou autorisé en fonction de la position de l'élément de commande (6).

3. Appareil ménager selon la revendication 2, **caractérisé en ce que** l'élément conducteur de rayonnement (4) est en partie imperméable au rayonnement d'émission et/ou de réception (L, L').

4. Appareil ménager selon l'une des revendications 1 à 3, **caractérisé en ce que** l'élément conducteur de rayonnement (4) est aménagé de telle sorte que le rayonnement d'émission (L) est dirigé de l'élément d'émission (2) en direction de l'élément de réception (3) en fonction de la position de l'élément de commande (6).

5. Appareil ménager selon l'une des revendications 1 à 4, **caractérisé en ce que** l'élément conducteur de rayonnement (4) est au moins partiellement transparent pour le rayonnement d'émission et/ou de réception (L, L').

6. Appareil ménager selon l'une des revendications 1 à 5, **caractérisé en ce que** l'élément conducteur de rayonnement (4) est aménagé afin de réfléchir le rayonnement d'émission (L) en direction de l'élément de réception (3) en fonction de la position de l'élément de commande (6).

7. Appareil ménager selon l'une des revendications 1 à 6, **caractérisé en ce que** l'élément d'émission (2) et l'élément de réception (3) sont disposés l'un à côté de l'autre sur une plaque de support commune (5).

8. Appareil ménager selon la revendication 7, **caractérisé en ce que** l'élément conducteur de rayonnement (4) est disposé de façon mobile en face de la plaque de support (5), de l'élément d'émission (2) et de l'élément de réception (3).

9. Appareil ménager (1) selon la revendication 7 ou 8, **caractérisé en ce que** l'élément d'émission (2) est aménagé afin d'émettre essentiellement le rayonnement d'émission (L) à la verticale de la plaque de support (5).

10. Appareil ménager selon l'une des revendications 7 à 9, **caractérisé en ce que** l'élément de réception (3) est aménagé afin de percevoir le rayonnement de réception (L') essentiellement à la verticale par rapport à la plaque de support (5).

11. Appareil ménager selon l'une des revendications 1 à 10, en outre avec un élément de commande (6) auquel l'élément conducteur de rayonnement (4) est couplé.

12. Appareil ménager selon l'une des revendications 1 à 11, **caractérisé en ce que** le rayonnement d'émission et/ou de réception (L, L') est un rayonnement optique, en particulier un rayonnement infrarouge.

13. Appareil ménager selon l'une des revendications 1 à 12, lequel étant un champ de cuisson à gaz.
